# EUROPÄISCHE PATENTSCHRIFT

(11) **EP 3 038 852 B1**
(45) Veröffentlichungstag und Bekanntmachung des Hinweises auf die Patenterteilung: **22.06.2022**
(21) Anmeldenummer: 14748220.2
(22) Anmeldetag: 08.08.2014
(51) Int. Cl.: G01R 31/36, H02J 7/14, B60R 16/03

(54) **ENERGIEMANAGEMENT-STEUERGERÄT UND VERFAHREN ZUR ERMITTLUNG EINER KENNGRÖSSE EINES ELEKTROCHEMISCHEN ENERGIESPEICHERS**
ENERGY MANAGEMENT CONTROL DEVICE AND METHOD FOR DETERMINING A CHARACTERISTIC VARIABLE OF AN ELECTROCHEMICAL ENERGY STORAGE MEANS
APPAREIL DE COMMANDE DE GESTION ÉNERGÉTIQUE ET PROCEDE POUR DETERMINER UNE CARACTÉRISTIQUE D'UN ACCUMULATEUR D'ÉNERGIE ÉLECTROCHIMIQUE

(30) Priorität: 27.08.2013 DE 102013217045
(43) Veröffentlichungstag der Anmeldung: 06.07.2016
(73) Patentinhaber: Volkswagen AG, 38440 Wolfsburg (DE)
(72) Erfinder: BAUMGARTH, Marco, 38533 Vordorf-Eickhorst (DE)
(86) Internationale Anmeldenummer: PCT/EP2014/067066
(87) Internationale Veröffentlichungsnummer: WO 2015/028282

(56) Entgegenhaltungen:
- EP-A2- 1 283 424
- DE-A1- 10 046 631
- DE-A1-102007 006 477
- DE-A1-102010 032 280

## Beschreibung

### Stand der Technik

Die vorliegende Erfindung betrifft ein Energiemanagement-Steuergerät für ein Fortbewegungsmittel sowie ein Verfahren zur Ermittlung einer Kenngröße eines elektrochemischen Energiespeichers zur Versorgung eines Bordnetzes eines Fortbewegungsmittels. Insbesondere betrifft die vorliegende Erfindung eine vorteilhafte Verwendung einfach ermittelbarer Daten zur Erhöhung eines Wirkungsgrades beim Betrieb eines Fortbewegungsmittels.

In Fahrzeugen mit Rekuperation ("Energierückgewinnung", "Bremsenergierückgewinnung") wird üblicherweise durch den Batteriesensor die Starterbatterie diagnostiziert. Ermittelt die Sensorik einen hohen Ladezustand (SOC, State of Charge) sowie einen ausreichenden Gesundheitszustand (State of Health, SOH) sowie eine bisher nicht auffällige Zyklisierung (Minderung der aktivierbaren Batteriekapazität), so wird die Funktion Rekuperation aktiviert. Durch die Rekuperationsfunktion wird, gesteuert durch einen Primär-Energiebewerter (im Allgemeinen das Motorsteuergerät, MSG) dem Niedervolt-Energiemanagement (NVEM) eine Aufwandsbewertung der elektrischen Energieerzeugung übermittelt. Das NVEM erzeugt durch Erhöhung der Spannung in günstigen Phasen (z.B. Schub mit Kraftstoffschubabschaltung) einen Energievorhalt in der Batterie (z.B. 12 Volt-Batterie), der in "teuren Phasen" (z.B. Beschleunigung) über Batterieentladung ("Rückspeisung") aus der Batterie entnommen wird und somit die minder zu erzeugende elektrische Energie die Kurbelwelle der Verbrennungskraftmaschine entlastet und somit der Kraftstoffverbrauch verringert wird. Für eine vorgenannte Verwendung in einer Batterie gespeicherter elektrischer Energie (Rekuperationsfunktion) ist in herkömmlichen Kraftfahrzeugen stets ein Batterie-Daten-Modul (BDM) vorgesehen, mit Hilfe dessen die Leistungsfähigkeit/Ladeakzeptanz der Batterie ermittelt wird. Das BDM ist mit relativ komplexer und leistungsfähiger Analysehardware und -software ausgestattet, wodurch eine vergleichsweise exakte Bestimmung des Batteriezustandes möglich ist. Die erforderliche Hardware und Software ist jedoch kostenintensiv.

DE 102 56 588 B4 zeigt ein Verfahren und eine Vorrichtung für die Zustandserkennung, bei welchen vordefinierte Belastungszustände im Zuge einer Betriebszustandsüberwachung verwendet werden. Die Druckschrift schlägt vor, die Batteriespannung beim Startvorgang über einen vorbestimmten Zeitraum zu messen, einen minimalen Spannungspegel der Kraftfahrzeugbatterie während des Startvorgangs einer Brennkraftmaschine zu ermitteln und im Ladezustand der Fahrzeugbatterie auf Grundlage des minimalen Spannungspegels zu bewerten. Eine ausreichende Versorgung des Bordnetzes wird anschließend durch Steuern eines elektrischen Generators in Abhängigkeit des Bewertungsergebnisses sichergestellt.

DE 43 07 907 A1 offenbart ein Verfahren zur Regelung eines Generators in einem Kraftfahrzeug, bei welchem in Abhängigkeit von Fahrzuständen ("Beschleunigen" und "Bremsen") eine Sollspannung für eine Generatorausgangsspannung festgelegt wird.

Aus der DE 100 46 631 A1 ist ein Verfahren zur Regelung eines Generators in einem Kraftfahrzeug bekannt, wobei der Generator ein Bordnetz mit Verbrauchern und mindestens einer Batterie speist, wobei ein Regler die Generatorspannung auf eine Sollwertspannung einregelt. In einem Rekuperationsbereitschaftsmodus wird die Sollwertspannung in Abhängigkeit der Fahrzustandsgrößen so vorgegeben, dass beim Abbremsen oder im Schubbetrieb des Fahrzeugs elektrische Energie in das Bordnetz eingespeist wird. Weiter wird in Abhängigkeit von vorgegebenen Umschaltbedingungen zwischen dem Rekuperationsbereitschaftsmodus und einem Erholungsmodus umgeschaltet, wobei im Erholungsmodus die Sollwertspannung so vorgegeben wird, dass sich die Batterie regeneriert.

Aus der EP 1 283 44 A2 ist ein Verfahren zur Bestimmung des Ladezustands einer Fahrzeugbatterie mit folgenden Schritten bekannt:
- Aktivieren des Ladezustandsbestimmungsbetriebes
- Einstellung eines definierten Laststromes für die Fahrzeugbatterie durch Ansteuerung mindestens einer E-Maschine des Fahrzeugs,
- Ableiten einer von der gemessenen Bordnetzspannung abhängigen Spannungscharakteristik,
- Bereitstellung einer Information über die Batterietemperatur des Fahrzeugs, und
- Ermittlung des Ladezustands der Fahrzeugbatterie unter Verwendung der Spannungscharakteristik, der Batterietemperatur und eines abgespeicherten Kennfeldes.

Aus der DE 10 2010 032 280 A1 ist eine Messeinheit für einen Energiespeicher im Bordnetz eines Fahrzeuges bekannt, wobei das Bordnetz einen Generator zur Stromversorgung für zumindest einen Energieverbraucher im Bordnetz aufweist. Dabei ermittelt die Messeinheit während der Zeit, wo der Generator weder einen Strom in das Bordnetz einspeist noch einen Strom von dem Bordnetz abzieht, den Innenwiderstand des Energiespeichers.

Aus der DE 10 2007 006 477 A1 ist ein gattungsgemäßes Verfahren zur Ermittlung einer Kenngröße eines elektrochemischen Energiespeichers zur Versorgung eines Bordnetzes eines Fortbewegungsmittels bekannt.

Der Erfindung liegt das Problem zugrunde, ein gattungsgemäßes Verfahren weiter zu verbessern sowie ein zugehöriges Energiemanagement-Steuergerät zu schaffen sowie ein damit ausgestattetes Fortbewegungsmittel zur Verfügung zu stellen. Offenbarung der Erfindung

Die vorstehend genannte Aufgabe wird erfindungsgemäß durch ein Verfahren mit den Merkmalen gemäß Anspruch 1 sowie ein Energiemanagement-Steuergerät mit den Merkmalen gemäß Anspruch 10 und ein Fortbewegungsmittel mit den Merkmalen des Anspruchs 11 gelöst. Das erfindungsgemäße Verfahren dient der Ermittlung einer Kenngröße eines elektrochemischen Energiespeichers zur Versorgung eines Bordnetzes eines Fortbewegungsmittels. Dabei kann das Verfahren auch ohne ein im Fortbewegungsmittel vorhandenes Batterie-Daten-Modul ausgeführt werden, da eine komplexe Auswertung des Zustandes des elektrochemischen Energiespeichers nicht erforderlich ist und daher nicht erfolgt. Die Kenngröße des elektrochemischen Energiespeichers kann beispielsweise ein aus einer Klemmenspannung und/oder einem SOC und/oder einem SOH des elektrochemischen Energiespeichers ermittelt werden. Erfindungsgemäß wird ein vordefinierter Betriebszustand des Bordnetzes ermittelt. Dieser kann beispielsweise an den Betrieb einer vordefinierten Vielzahl elektrischer Verbraucher gekoppelt sein. Mit anderen Worten kann ermittelt werden, welche elektrischen Verbraucher derzeit elektrische Leistung aus dem Bordnetz beziehen und, sofern die aktiven Verbraucher des Fahrzeugs einem vordefinierten Kriterium entsprechen, der vordefinierte Betriebszustand erkannt werden. Auf diese Weise wird eine nicht quantifizierbare Leistungsanfrage an das Bordnetz angeschlossener Verbraucher vermieden. Indem die Verbraucher insbesondere solche sind, die im Betrieb des Fortbewegungsmittels eine weitere Funktion aufweisen, wird eine eigens für die Kenngrößenermittlung vorgesehene Last erübrigt. Zusätzlich wird eine Spannung des elektrochemischen Energiespeichers während des vordefinierten Betriebszustandes gemessen. Dabei kann die Spannung ohne aufwändige Hard- und Software, beispielsweise durch ein Motorsteuergerät (MSG) oder ein Bordnetzenergiemanagementsystem (BEM) ermittelt werden. Insofern, als während dieser Zeit ein vordefinierter Betriebszustand mit bekannten aktiven Verbrauchern vorherrscht, kann aus der gemessenen Spannung in Verbindung mit einer bekannten Last ein Innenwiderstand des elektrochemischen Energiespeichers ermittelt werden. Entsprechend schlägt das erfindungsgemäße Verfahren weiter ein Ermitteln der Kenngröße des elektrochemischen Energiespeichers auf Basis der ermittelten Spannung und einer dem vordefinierten Betriebszustand zugeordneten Referenz vor. Dabei kann die zugeordnete Referenz als Wert, Werteschar oder Kennfeld abgespeichert sein und zur Ermittlung der Kenngröße in Abhängigkeit der ermittelten Spannung und gegebenenfalls weiterer Werte ausgelesen werden. Erfindungsgemäß beginnt der vordefinierte Betriebszustand nach einem Betätigen einer Zugangsfunktion des Fortbewegungsmittels. Dies kann beispielsweise das Betätigen einer Zentralverriegelung (z.B. durch Umdrehen eines Schlüssels in einem Türschloss, Betätigen einer Funkfernbedienung o.Ä.) umfassen. Dabei endet der vordefinierte Betriebszustand vor einem Starten eines Verbrennungsmotors des Fortbewegungsmittels. Das vorstehend beschriebene Betriebszustandsintervall zeichnet sich dadurch aus, dass im Wesentlichen ausschließlich elektrische Verbraucher betrieben werden, deren Leistungsaufnahme (ggf. in Abhängigkeit einer Temperatur) sehr gut vorhersehbar ist. Demgegenüber ist das im Stand der Technik bekannte Starten einer Verbrennungsmaschine durch eine Vielzahl unvorhersehbarer Parameter gekennzeichnet, so dass sich eine durch den Starter des Verbrennungsmotors bezogene elektrische Leistung zur Ermittlung einer Kenngröße des elektrochemischen Energiespeichers weniger eignet. Das vorstehend beschriebene Verfahren bietet den Vorteil einer einfachen Hardware bei geeigneter Genauigkeit der ermittelten Kenngröße.

Weiter ist der vordefinierte Betriebszustand so definiert, dass er einen Betrieb von einem Anwender des Fortbewegungsmittels willkürlich aktivierter elektrischer Verbraucher ausschließt. Mit anderen Worten wird ein solcher Betriebszustand gewählt, in welchem durch einen Anwender aktivierbare Verbraucher innerhalb des Bordnetzes noch nicht auf Anwendereingaben reagieren. Alternativ kann für den vordefinierten Betriebszustand eine Vielzahl elektrischer Verbraucher vordefiniert sein, deren durch einen Anwender initiierbaren Leistungsaufnahmen zuvor ermittelt, abgespeichert und während des vordefinierten Betriebszustandes erkannt, ausgelesen und bei der Spannungsmessung bzw. Kenngrößenermittlung berücksichtigt werden können. Beispielsweise kann der vordefinierte Betriebszustand auch eine Aktivierung eines vordefinierten Verbrauchers oder mehrerer vordefinierter Verbraucher umfassen, um eine geeignete elektrische Last durch das Bordnetz des Fortbewegungsmittels bereitzustellen. Beispielsweise kann eine Heizfunktion (z.B. Heckscheibenheizung und/oder Sitzheizung und/oder Rückspiegelheizung und/oder Lenkradheizung) aktiviert werden, wodurch ein in Abhängigkeit einer Temperatur vordefinierter Belastungszustand relativ exakt hergestellt wird. Durch die vorstehenden Definitionen eines vordefinierten Betriebszustandes kann eine sehr exakte und geeignete Last durch das Bordnetz realisiert werden, so dass über eine Spannungsmessung eine hinreichend genaue Ermittlung einer Kenngröße des elektrochemischen Energiespeichers erfolgen kann.

Bevorzugt kann zusätzlich eine Nutzungshistorie des Fortbewegungsmittels berücksichtigt werden. Unter der Nutzungshistorie wird im Rahmen der vorliegenden Erfindung die Vielzahl an im Fahrzeug gespeicherten Daten verstanden, welche Aufschluss auf den aktuellen Zustand des Fortbewegungsmittels geben und auf zeitlich zurückliegenden Betriebszuständen basieren. Beispielsweise wird die Zeit seit einem letzten Motorstart üblicherweise im Motorsteuergerät abgelegt. Auf Basis der Kenntnis eines Zeitpunktes eines letzten, zeitlich zurückliegenden Motorlaufes kann beispielsweise auf eine seit diesem Zeitpunkt erfolgte Selbstentladung des elektrochemischen Energiespeichers geschlossen werden. Alternativ oder zusätzlich kann ein Temperatursignal, insbesondere eine Kühlmitteltemperatur, berücksichtigt werden. Eine hohe Kühlmitteltemperatur lässt dabei zusätzlich auch auf einen kürzlich zurückliegenden Motorlauf und eine entsprechende Ladung des elektrochemischen Energiespeichers durch den Generator schließen. Die vorstehend genannten Daten sind besonders hilfreich bei der Beurteilung eines aktuellen Zustandes der Komponenten des Fahrzeugbordnetzes und stehen bereits bei in Serie befindlichen Fortbewegungsmitteln zur Verfügung, so dass zusätzliche Algorithmen und Aufwendungen zu ihrer Ermittlung nicht erforderlich sind.

Als Kenngröße für den elektrochemischen Energiespeicher haben sich die im Stand der Technik bekannten Werte "SOH" und/oder "SOC" bewährt. Alternativ oder zusätzlich kann die Referenz ein dem vordefinierten Betriebszustand zugeordneter Spannungswert sein. Dabei kann in Abhängigkeit eines aktuellen Betriebszustandes ein gespeicherter, vordefinierter Betriebszustand ausgelesen und ein ihm zugeordneter Spannungswert dahingehend beurteilt werden, ob er oberhalb oder unterhalb eines aktuellen Spannungswertes des elektrochemischen Energiespeichers liegt. Außerdem kann eine quantitative Bewertung eines aktuellen Spannungswertes hinsichtlich des zugeordneten Spannungswertes erfolgen, um einen genaueren Aufschluss über den aktuellen Zustand des elektrochemischen Energiespeichers zu ermöglichen. Auf diese Weise ist eine kostengünstige Realisierung einer weiteren Optimierung einer Erhöhung eines Wirkungsgrades beim Betrieb eines Fortbewegungsmittels möglich.

Gemäß einem weiteren Aspekt der vorliegenden Erfindung wird ein Verfahren zum Regeln einer Generatorspannung eines Bordnetzes eines Fortbewegungsmittels vorgeschlagen, wobei das Fortbewegungsmittel insbesondere kein Batterie-Daten-Modul (BDM) aufweist. Die Generatorspannung kann beispielsweise unter Vermittlung eines Verbrennungsmotors des Fortbewegungsmittels erzeugt werden. Das Verfahren umfasst ein Ermitteln einer Kenngröße für die Leistungsfähigkeit (z.B. eine Klemmenspannung, ein SOC und/oder ein SOH) eines elektrochemischen Energiespeichers innerhalb des Bordnetzes des Fortbewegungsmittels. Das Ermitteln kann durch ein erfindungsgemäßes Verfahren gemäß dem oben beschriebenen ersten Erfindungsaspekt erfolgen. Mit anderen Worten kann ein vordefinierter Betriebszustand ermittelt, eine Spannung des elektrochemischen Energiespeichers während des vordefinierten Betriebszustandes gemessen und unter Verwendung einer dem vordefinierten Betriebszustand zugeordneten Referenz die gewünschte Kenngröße ermittelt werden. Zudem umfasst das Verfahren zum Regeln der Generatorspannung ein Kategorisieren eines aktuellen Betriebszustandes hinsichtlich eines Aufwandes an chemisch gespeicherter Energie zum Wandeln kinetischer Energie des Fortbewegungsmittels in elektrische Energie. Der Aufwand an chemisch gespeicherter Energie kann der aktuell erforderliche Kraftstoffeinsatz oder in einem elektrochemischen Energiespeicher gespeicherte Energie sein. Mit anderen Worten wird für einen aktuellen oder kurzfristig bevorstehenden Betriebszustand bestimmt, in welchem Maße bereits gespeicherte Energie aufgewandt werden muss, um einen Generator des Fortbewegungsmittels anzutreiben. Zwei einfache Kategorien bestehen in den Betriebszuständen "Schub" und "Zug". Während des Zugs wird antriebsseitig Energie in die Fortbewegung des Fortbewegungsmittels investiert. Während des Schubs verringert sich die kinetische Energie des Fortbewegungsmittels, wobei Energie von einer Antriebseinheit des Fortbewegungsmittels (und zum Beispiel auch eines Generators in Verbindung mit einem elektrochemischen Energiespeicher) aufgenommen wird. Während die kinetische Energie des Fortbewegungsmittels während des Zuges kostspielig ist, da eine generatorische Wandlung von Energie ein erhöhtes Antriebsmoment einer Antriebsmaschine des Fortbewegungsmittels erfordert, ist eine Erhöhung der Generatorspannung und damit seiner aktuellen Leistung nahezu kostenlos, wenn ohnehin keine Energie in die Fortbewegung des Fortbewegungsmittels investiert wird. Im Ansprechen auf eine Kategorie mit niedrigem Energieaufwand als auch im Ansprechen auf eine Kenngröße des elektrochemischen Energiespeichers, die eine höhere Leistungsfähigkeit des elektrochemischen Energiespeichers erkennen lässt, als durch einen Schwellwert bzw. eine Referenz definiert ist, wird die Generatorspannung auf einen ersten vordefinierten Wert abgesenkt. Mit anderen Worten wird somit erkannt, dass Energie zum Antrieb des Generators zwar kostengünstig verfügbar ist, der Zustand des elektrochemischen Energiespeichers jedoch ein Laden unnötig erscheinen lässt. Im Ansprechen darauf wird, obwohl eine Wandlung kinetischer Energie (des Fortbewegungsmittels oder des Antriebsstrangs) kostengünstig zur Verfügung stünde, die Generatorspannung abgesenkt, wodurch zwar weniger kinetische Energie durch den Generator in elektrische Energie gewandelt wird, als dies im Stand der Technik bei ungeregelten Generatoren der Fall ist, jedoch die Ausgangsspannung des Generators weiterhin so hoch gewählt wird, dass eine Entladung des elektrochemischen Energiespeichers nicht stattfindet. Auf diese Weise wird in einem einfachen Aufbau eine Zyklisierung des elektrochemischen Energiespeichers verhindert, während dennoch erhebliche Wirkungsgradvorteile beim Betrieb des Fortbewegungsmittels erzielt werden können. Dem Fachmann ist ersichtlich, dass zusätzlich auch in einem Betriebszustand mit hohem Aufwand an chemisch gespeicherter Energie und während die Kenngröße des elektrochemischen Energiespeichers auf einen besseren Zustand als durch eine Referenz vordefiniert ist, die Generatorspannung auf den ersten vordefinierten Wert abgesenkt werden kann. Dies bietet eine zusätzliche Möglichkeit, den Wirkungsgrad beim Betrieb des Fortbewegungsmittels weiter zu erhöhen.

Bevorzugt wird im Ansprechen auf sowohl eine Kategorie mit niedrigem Aufwand als auch im Ansprechen auf eine Kenngröße des elektrochemischen Energiespeichers, die in einem zweiten vordefinierten Verhältnis zu der abgespeicherten Referenz steht (z.B. eine geringere Leistungsfähigkeit als durch die Referenz vordefiniert anzeigt) kinetische Energie des Fortbewegungsmittels in elektrische Energie durch Anheben der Generatorspannung auf einen vordefinierten Wert gewandelt. Mit anderen Worten wird beim Erkennen eines Ladebedarfs des elektrochemischen Energiespeichers und der Tatsache, dass kostengünstige kinetische Energie zur Wandlung in elektrische Energie zur Verfügung steht, die Generatorspannung auf einen vordefinierten zweiten Wert angehoben. Der vordefinierte zweite Wert kann dabei beispielsweise einer üblicherweise zur Ladung einer vorliegenden Batterietechnologie verwendeten Spannung entsprechen. Auf diese Weise wird sichergestellt, dass eine maximale Verwendbarkeit des elektrochemischen Energiespeichers sichergestellt wird und hierzu ein geringstmöglicher Aufwand chemisch gespeicherter Energie betrieben wird.

Bevorzugt wird der erste vordefinierte Wert, auf welchen die Generatorspannung angesenkt wird, in Abhängigkeit einer Nennklemmenspannung des elektrochemischen Energiespeichers gewählt. Mit anderen Worten wird in Abhängigkeit der aktuell vorliegenden ("verwendeten") Speichertechnologie die Generatorausgangsspannung derart eingestellt, dass eine Entladung des elektrochemischen Energiespeichers zwar nicht erfolgt, die Bordnetzspannung bzw. die Generatorausgangsspannung diesen Wert jedoch nicht deutlich übersteigt. Auf diese Weise wird verhindert, dass die Leistungsaufnahme elektrischer Verbraucher im Bordnetz unnötigerweise erhöht wird. Wird nämlich beispielsweise statt einer Klemmenspannung von 13,2 Volt eine Bordnetzspannung jenseits der 14 V eingestellt, erhöhen sich z.B. ohmsche Verluste ungeregelter elektrischer Verbraucher (z.B. Leuchtmittel und einfache Heizelemente), wodurch sich der Aufwand chemisch gespeicherter Energie erhöht und zudem mehr Abwärme dieser Verbraucher erzeugt wird. Somit können z.B. auch zur Entwärmung erforderliche Aufwände geringer ausfallen und Verschleißerscheinungen in den Verbrauchern sowie im Generator verringert werden. Mögliche Spannungsbereiche für den ersten vordefinierten Wert liegen zwischen 12,9 und 13,7 Volt, bevorzugt zwischen 13,2 Volt und 13,5 Volt. In Abhängigkeit der Batterietechnologie kann durch erste vordefinierte Werte für die Generatorspannung in den vorstehend genannten Bereichen eine Entladung und somit Zyklisierung des elektrochemischen Energiespeichers wirksam verhindert werden.

Gemäß einem dritten Aspekt der vorliegenden Erfindung wird ein Energiemanagement-Steuergerät für ein Fortbewegungsmittel vorgeschlagen, welches eingerichtet ist, ein Verfahren gemäß dem erstgenannten und/oder dem zweitgenannten Erfindungsaspekt durchzuführen. Das Energiemanagement-Steuergerät kann dabei beispielsweise als BEM ausgeführt sein, während das Fortbewegungsmittel insbesondere nicht über ein Batterie-Datenmodul (BDM) verfügt. Das Energiemanagement-Steuergerät ist im Stande, einen vordefinierten Betriebszustand des Bordnetzes zu ermitteln oder mitgeteilt zu bekommen. Weiter kann es eine Spannung des elektrochemischen Energiespeichers während des vordefinierten Betriebszustandes entweder selbst messen oder ebenfalls von einer zusätzlichen Einheit empfangen. Auf Basis der Spannung und einer dem vordefinierten Betriebszustand zugeordneten Referenz kann das Energiemanagement-Steuergerät die Kenngröße des elektrochemischen Energiespeichers ermitteln. Der vordefinierte Betriebszustand beginnt dabei erfindungsgemäß durch oder nach einem Betätigen einer Zugangsfunktion, endet jedoch bevorzugt vor einem Starten eines Verbrennungsmotors des Fortbewegungsmittels. Auf diese Weise weist das Energiemanagementsteuergerät dieselben Merkmale und Vorteile auf, wie sie in Verbindung mit den erfindungsgemäßen Verfahrensaspekten oben beschrieben worden sind.

Zusätzlich wird ein Fortbewegungsmittel vorgeschlagen, welches einen elektrochemischen Energiespeicher, einen Spannungssensor zum Messen einer Spannung eines Bordnetzes des Fortbewegungsmittels und ein Energiemanagement-Steuergerät gemäß dem dritten Erfindungsaspekt umfasst. Das Signal des Spannungssensors kann dabei dem Energiemanagement-Steuergerät zum Ermitteln der Kenngröße des elektrochemischen Energiespeichers zugeführt werden.

### Kurze Beschreibung der Zeichnungen

Nachfolgend werden Ausführungsbeispiele der Erfindung unter Bezugnahme auf die begleitenden Zeichnungen im Detail beschrieben. In den Zeichnungen ist:
- Figur 1: eine schematische Übersicht über Komponenten eines erfindungsgemäßen Fortbewegungsmittels;
- Figur 2: ein Diagramm zur Bordnetzleistung über der Zeit; und
- Figur 3: ein Flussdiagramm, veranschaulichend Schritte eines Ausführungsbeispiels eines erfindungsgemäßen Verfahrens.

### Ausführungsformen der Erfindung

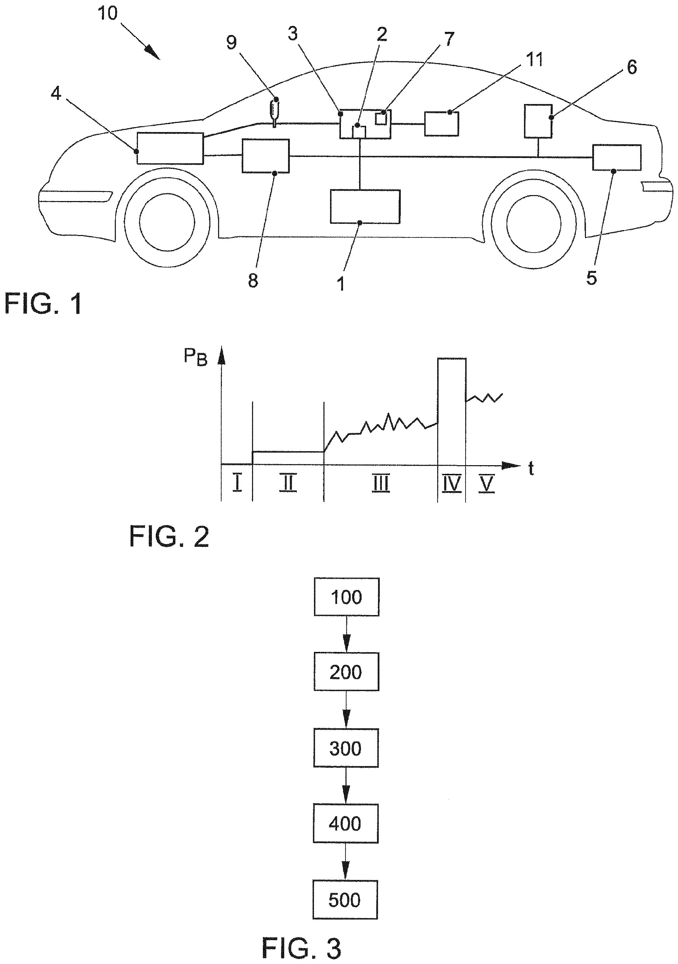

Figur 1 zeigt einen Pkw 10 als Fortbewegungsmittel, welcher einen Verbrennungsmotor 4 aufweist. Der Verbrennungsmotor 4 ist Teil des Antriebsstrangs des Pkws 10 und treibt einen elektrischen Generator 8 an. Über den Generator 8 wird eine Batterie 1 als elektrochemischer Energiespeicher geladen, wenn das Batteriemanagement-Steuergerät (BMS) 3 die Generatorspannung (bzw. Generatorerregerspannung) entsprechend einstellt.

Innerhalb des BMS 3 ist ein Spannungssensor 2 zur Ermittlung einer Bordnetzspannung bzw. Spannung der Batterie 1 angeordnet. Ein Datenspeicher 7 hält innerhalb des BMS 3 Referenzwerte zur Ermittlung der Kenngröße der Batterie 1 und zur Kategorisierung eines aktuellen Betriebszustandes bereit. Weiter ist das BMS 3 an einen Temperatursensor 9 angeschlossen, mittels dessen eine Kühlmitteltemperatur des Verbrennungsmotors 4 ermittelt werden kann. Zusätzlich ist das BMS 3 an das Motorsteuergerät (MSG) 11 angeschlossen, wodurch es Informationen über zeitlich zurückliegende Betriebszustände des Pkw 10 erhält. Weiter ist im Bordnetz ein willkürlich durch einen Anwender aktivierbarer Verbraucher 5 dargestellt, dessen Leistungsaufnahme in dem erfindungsgemäß vordefinierten Betriebszustand (siehe auch Figur 2, Bezugszeichen II) ausgeschlossen werden muss, um eine vordefinierte Gesamtlast bereitstellen zu können. Zusätzlich ist ein durch das Bordnetz aktivierbarer Verbraucher 6 dargestellt, der die Heckscheibenheizung, eine Sitzheizung und andere (z.B. ohmsche) Verbraucher mit vorhersehbarer elektrischer Leistungsaufnahme repräsentiert.

Figur 2 zeigt ein schematisches Leistungsdiagramm veranschaulichend eine Bordnetzleistung P_{B} über der Zeit t für ein Fortbewegungsmittel. In einem ersten Betriebszustand I befindet sich das abgeschlossene Fortbewegungsmittel in einem Ruhezustand. Die Leistungsaufnahme P_{B} ist vernachlässigbar. Durch das Betätigen einer Zentralverriegelung des Fortbewegungsmittels durch einen Anwender tritt das Fortbewegungsmittel in einen zweiten Betriebszustand II als vordefinierten Betriebszustand des Bordnetzes ein. In diesem Bereich ist die Zeitfolge des Aufwachens der elektrischen Verbraucher aus dem Ruhezustand im Wesentlichen durch vordefinierte Routinen festgelegt. Auf diese Weise wird bis zu einem Übertritt in einen dritten Betriebszustand III eine im Wesentlichen vordefinierte Last aktiviert, im Ansprechen worauf die erfindungsgemäße Spannungsmessung des elektrochemischen Energiespeichers und/oder des Bordnetzes erfolgen kann. In dem dritten Betriebszustand III ist der Anwender bereits in das Fortbewegungsmittel eingestiegen, so dass er durch Betätigen unterschiedlicher Bedieneinheiten willkürlich (weitere) elektrische Verbraucher aktivieren oder deaktivieren kann. Auf diese Weise sind eine Vielzahl unterschiedlicher Lastzustände in diesem Bereich generierbar, für welche keine abschließende Vielzahl von Referenzen im Fortbewegungsmittel gespeichert sein kann. Dies bedeutet jedoch nicht, dass für vorbestimmte Verbraucher erkannt werden kann, dass sie durch den Anwender aktiviert worden sind und ihre Leistungsaufnahme in Form einer Referenz oder zusätzlich zu einer Referenz (z.B. messtechnisch) berücksichtigt werden kann. Durch das Starten des Verbrennungsmotors tritt das Fortbewegungsmittel aus einem dritten Betriebszustand III in einen vierten Betriebszustand IV über, der durch eine hohe Bordnetzleistung P_{B} gekennzeichnet ist. Die in diesem Betriebszustand aufgenommene Leistung hängt jedoch von vielen unterschiedlichen Faktoren (z.B. Kühlmitteltemperatur, Schmiermitteltemperatur, Schmiermittelviskosität etc.) ab, so dass sich dieser Betriebszustand nicht als vordefinierter Betriebszustand zur Spannungsmessung im Zuge einer erfindungsgemäßen Beurteilung eines elektrochemischen Energiespeichers nicht ohne Weiteres eignet. Nach erfolgtem Starten des Verbrennungsmotors tritt das Bordnetz aus dem vierten Betriebszustand IV in einen fünften Betriebszustand 5 über, der sich durch aufgrund eines Betriebes des Verbrennungsmotors aktivierte zusätzliche Verbraucher (z.B. Lüfter, Zündanlage) sowie einen optional angetriebenen Generator von dem dritten Betriebszustand III unterscheidet, so dass eine höhere elektrische Leistung P_{B} im Betriebszustand V umgesetzt wird als während des Betriebszustandes III.

Figur 3 zeigt ein Flussdiagramm, veranschaulichend Schritte eines Ausführungsbeispiels eines erfindungsgemäßen Verfahrens. In Schritt 100 wird ein vordefinierter Betriebszustand des Bordnetzes ermittelt. Mit anderen Worten wird erkannt, dass der vordefinierte Betriebszustand vorliegt. Anschließend wird in Schritt 200 eine Spannung des elektrochemischen Energiespeichers während des vordefinierten Betriebszustandes gemessen. Schließlich wird in Schritt 300 die Kenngröße des elektrochemischen Energiespeichers auf Basis der ermittelten Spannung und einer dem vordefinierten Betriebszustand zugeordneten Referenz ermittelt. Erfindungsgemäß wird als vordefinierter Betriebszustand ein sich an das Betätigen einer Zugangsfunktion des Fortbewegungsmittels anschließender Betriebszustand vorgeschlagen. Dieser endet bevorzugt vor einem Starten eines Verbrennungsmotors des Fortbewegungsmittels. Die vorgenannten Schritte 100 bis 300 können Grundlage einer bevorzugten Ausgestaltung des erfindungsgemäßen Verfahrens sein, durch welches eine Generatorspannung in vorteilhafter Weise geregelt wird. Hierzu wird im Anschluss an den Schritt 300 in Schritt 400 ein Kategorisieren eines aktuellen Betriebszustandes des Fortbewegungsmittels hinsichtlich eines Aufwandes an chemisch gespeicherter Energie zum Wandeln kinetischer Energie (z.B. einer Welle eines Antriebsstranges oder der fahrtbedingt bewegten Masse) des Fortbewegungsmittels in elektrische Energie vorgenommen. Im Ansprechen auf sowohl eine ermittelte Kategorie mit niedrigem Aufwand als auch im Ansprechen auf eine Kenngröße des elektrochemischen Energiespeichers, die in einem ersten vordefinierten Verhältnis zu einer abgespeicherten Referenz steht, wird in Schritt 500 die Generatorspannung auf einen ersten vordefinierten Wert abgesenkt. Dies verringert die Leistungsaufnahme elektrischer Verbraucher im Bordnetz und erhöht den Wirkungsgrad beim Betrieb des erfindungsgemäßen Fortbewegungsmittels.

Es ist ein Kerngedanke der vorliegenden Erfindung, im Gegensatz zu aus dem Stand der Technik bekannten Anordnungen eine kostengünstige Realisierung von Wirkungsgradverbesserungen beim Betrieb eines Fortbewegungsmittels zu ermöglichen. Für eine Untersuchung des Zustandes des elektrochemischen Energiespeichers wird dabei eine Spannungsmessung innerhalb eines vordefinierten Betriebszustandes des Bordnetzes vorgeschlagen, wobei der vordefinierte Betriebszustand eine durch eine bestimmte oder bestimmbare Vielzahl Verbraucher realisierte, geeignete und bekannte Gesamtlast bereitstellt. In einer Weiterbildung kann daher durch Einsteigen eines Anwenders in das Fortbewegungsmittel erkannt werden (z.B. durch Sitzbelegungserkennung, wie sie im Stand der Technik bekannt ist) und der vordefinierte Betriebszustand im Ansprechen auf das Einsteigen als beendet definiert werden. Eine auf diese Weise erfolgte Beurteilung des elektrochemischen Energiespeichers kann Grundlage eines Verfahrens zum Regeln einer Generatorspannung des Bordnetzes des Fortbewegungsmittels sein. Die vorliegende Erfindung ermöglicht eine Wirkungsgraderhöhung auch in Fahrzeugen ohne BDM, sofern ein Generator mit regelbarer Erregerspannung (z.B. LIN-Generator) verbaut ist. Durch eine einfache analoge Spannungssensorik und eine daraus ermittelbare Spannungsreaktion der Batterie auf bekannte Belastungen kann in eingeschränktem Maße auf die Leistungsfähigkeit der Batterie geschlossen werden. Eine dabei nicht ermittelbare Genauigkeit wird erfindungsgemäß dadurch ausgeglichen, dass während der Rekuperation bzw. Absenkung der Erregerspannung in den "Teuer-Phasen" zwar eine Spannungsabsenkung des Generators ausgelöst wird, diese angesteuerte Spannung aber oberhalb der Leerlaufspannung einer vollgeladenen Batterie liegt. Somit wird eine Cyclisierung der Batterie, die erfindungsgemäß nicht messtechnisch überwacht werden muss, vermieden. Auf diese Weise ermöglicht die vorliegende Erfindung eine Erhöhung des Wirkungsgrades beim Betrieb eines erfindungsgemäßen Fortbewegungsmittels auch für Märkte, in welchen mit Start/Stopp-Automatik ausgestattete Fahrzeuge aus Kostengründen weniger zahlreich oder überhaupt nicht nachgefragt werden. Im Umkehrschluss wird es möglich, in diesen Märkten Fahrzeuge mit Verbrauchsvorteilen kostengünstig anzubieten.

Auch wenn die erfindungsgemäßen Aspekte und vorteilhaften Ausführungsformen anhand der in Verbindung mit den beigefügten Zeichnungsfiguren erläuterten Ausführungsbeispiele im Detail beschrieben worden sind, sind für den Fachmann Modifikationen und Kombinationen von Merkmalen der dargestellten Ausführungsbeispiele möglich, ohne den Bereich der vorliegenden Erfindung zu verlassen, deren Schutzbereich durch die beigefügten Ansprüche definiert wird.

### Bezugszeichenliste

- 1: Batterie
- 2: Spannungssensor
- 3: Batteriemanagement-Steuergerät (BMS)
- 4: Verbrennungsmotor
- 5: Verbraucher (willkürlich aktivierbar)
- 6: Verbraucher (durch Bordnetz aktivierbar)
- 7: Speicher
- 8: Generator
- 9: Temperatursensor
- 10: PKW
- 11: Motorsteuergerät (MSG)
- 100-500: Verfahrensschritte
- P_{B}: Bordnetzleistung
- I: Ruhezustand
- II: Betriebszustand nach Betätigen einer Zugangsfunktion
- III: Betriebszustand nach dem Einsteigen
- IV: Betriebszustand bei Motorstart
- V: Betriebszustand nach erfolgreichem Motorstart

## Patentansprüche

1. Verfahren zur Ermittlung einer Kenngröße eines elektrochemischen Energiespeichers (1) zur Versorgung eines Bordnetzes eines Fortbewegungsmittels (10), insbesondere eines Fortbewegungsmittels (10) ohne Batterie-Daten-Modul, umfassend die Schritte:
- Ermitteln (100) eines vordefinierten Betriebszustandes (II) des Bordnetzes,
- Messen (200) einer Spannung des elektrochemischen Energiespeichers (1) während des vordefinierten Betriebszustandes (II), und
- Ermitteln (300) der Kenngröße des elektrochemischen Energiespeichers (1) auf Basis der ermittelten Spannung und einer dem vordefinierten Betriebszustand (II) zugeordneten Referenz, wobei
der vordefinierte Betriebszustand (II) nach einem Betätigen einer Zugangsfunktion beginnt, jedoch vor einem Starten (IV) eines Verbrennungsmotors (4) des Fortbewegungsmittels (10) endet,
**dadurch gekennzeichnet, dass** der vordefinierte Betriebszustand (II) einen Betrieb von einem Anwender des Fortbewegungsmittels (10) willkürlich aktivierter elektrische Verbraucher (5) ausschließt.

2. Verfahren nach Anspruch 1, wobei der vordefinierte Betriebszustand (II)
- durch das Betätigen der Zugangsfunktion gestartet wird.

3. Verfahren nach Anspruch 1 oder 2, wobei
- im vordefinierten Betriebszustand (II) eine zeitgleiche elektrische Leistungsaufnahme eines vordefinierten Verbrauchers (6) durch Verwendung eines dem vordefinierten Verbraucher (6) zugeordneten, gespeicherten Wertes berücksichtigt wird, und/oder wobei
- eine Nutzungshistorie des Fortbewegungsmittels (10), und/oder
- ein Temperatursignal, insbesondere eine Kühlmitteltemperatur, und/oder
- eine Zeitdauer seit einem jüngsten, zurückliegenden Betrieb eines Verbrennungsmotors (4) des Fortbewegungsmittels (10) bei der Ermittlung der Kenngröße berücksichtigt wird.

4. Verfahren nach einem der vorstehenden Ansprüche, wobei die Kenngröße auf einem SOH und/oder einem SOC basiert und/oder die Referenz ein dem vordefinierten Betriebszustand (II) zugeordneter Spannungswert ist.

5. Verfahren zum Regeln einer Generatorspannung eines Bordnetzes eines Fortbewegungsmittels (10), insbesondere eines Fortbewegungsmittels (10) ohne Batterie-Daten-Modul, umfassend die Schritte:
- Ermitteln (300) einer Kenngröße für die Leistungsfähigkeit eines elektrochemischen Energiespeichers (1) innerhalb des Bordnetzes des Fortbewegungsmittels (10) durch ein Verfahren gemäß einem der vorstehenden Ansprüche,
- Kategorisieren (400) eines aktuellen Betriebszustandes hinsichtlich eines Aufwandes an chemisch gespeicherter Energie zum Wandeln kinetischer Energie des Fortbewegungsmittels (10) in elektrische Energie, und im Ansprechen auf sowohl eine Kategorie mit niedrigem Aufwand als auch im Ansprechen auf eine Kenngröße des elektrochemischen Energiespeichers (1), die in einem ersten vordefinierten Verhältnis zu einer abgespeicherten Referenz steht, insbesondere höher als ein Schwellenwert ist,
- Absenken (500) der Generatorspannung auf einen ersten vordefinierten Wert.

6. Verfahren nach Anspruch 5, weiter umfassend die Schritte im Ansprechen auf sowohl eine Kategorie mit niedrigem Aufwand als auch im Ansprechen auf eine Kenngröße des elektrochemischen Energiespeichers (1), die in einem zweiten vordefinierten Verhältnis zu der abgespeicherten Referenz steht, insbesondere niedriger als ein Schwellenwert ist,
- Wandeln kinetischer Energie des Fortbewegungsmittels (10) in elektrische Energie durch Anheben der Generatorspannung auf einen vordefinierten zweiten Wert.

7. Verfahren nach Anspruch 5 oder 6, wobei der vordefinierte Wert, auf welchen die Generatorspannung abgesenkt wird, in Abhängigkeit einer Nennklemmenspannung des elektrochemischen Energiespeichers (1) gewählt wird.

8. Verfahren nach einem der vorstehenden Ansprüche 5 bis 7, wobei der erste vordefinierte Wert eine Spannung im Bereich zwischen 12,9 V und 13,7 V, bevorzugt zwischen 13,2 V und 13, 5 V, repräsentiert.

9. Verfahren nach einem der vorstehenden Ansprüche 5 bis 8, wobei
- die Kategorie mit niedrigem Aufwand einem Schubbetriebszustand des Fortbewegungsmittels (10) zugeordnet ist und/oder
- die Kategorie mit höherem Aufwand einem Zugbetriebszustand des Fortbewegungsmittels (10) zugeordnet ist.

10. Energiemanagement-Steuergerät für ein Fortbewegungsmittel (10), welches eingerichtet ist, ein Verfahren gemäß einem der vorstehenden Ansprüche durchzuführen.

11. Fortbewegungsmittel umfassend
- einen elektrochemischen Energiespeicher (1),
- einen Spannungssensor (2) zum Messen einer Spannung eines Bordnetzes des Fortbewegungsmittels (10), und
- ein Energiemanagement-Steuergerät (3) nach Anspruch 10.

## Claims

1. Method for determining a parameter of an electrochemical energy storage system (1) for supplying an on-board power system of a means of transport (10), in particular a means of transport (10) without a battery data module, comprising the steps of:
- determining (100) a predefined operating state (II) of the on-board power system,
- measuring (200) a voltage of the electrochemical energy storage system (1) during the predefined operating state (II), and
- determining (300) the parameter of the electrochemical energy storage system (1) on the basis of the voltage determined and a reference associated with the predefined operating state (II), wherein
the predefined operating state (II) begins after activation of an access function but ends before starting (IV) of an internal combustion engine (4) of the means of transport (10),
**characterized in that** the predefined operating state (II) excludes operation of electrical loads (5) arbitrarily activated by a user of the means of transport (10).

2. Method according to claim 1, wherein the predefined operating state (II)
- is started by the activation of the access function.

3. Method according to claim 1 or 2, wherein
- in the predefined operating state (II), a simultaneous electrical power consumption of a predefined load (6) is taken into account by using a stored value associated with the predefined load (6), and/or wherein
- a usage history of the means of transport (10), and/or
- a temperature signal, in particular a coolant temperature, and/or
- a time period since a most recent, previous operation of an internal combustion engine (4) of the means of transport (10)
is taken into account when determining the parameter.

4. Method according to any one of the preceding claims, wherein the parameter is based on an SOH and/or an SOC, and/or the reference is a voltage value associated with the predefined operating state (II).

5. Method for controlling a generator voltage of an on-board power system of a means of transport (10), in particular a means of transport (10) without a battery data module, comprising the steps of:
- determining (300) a parameter for the performance of an electrochemical energy storage system (1) within the on-board power system of the means of transport (10) by a method according to any one of the preceding claims,
- categorizing (400) a current operating state with respect to a usage of chemically stored energy for converting kinetic energy of the means of transport (10) to electrical energy, and, in response to both a category with low usage and in response to a parameter of the electrochemical energy storage system (1) which is in a first predefined ratio to a stored reference, in particular is higher than a threshold value,
- lowering (500) the generator voltage to a first predefined value.

6. Method according to claim 5, further comprising the steps, in response to both a category with low usage and in response to a parameter of the electrochemical energy storage system (1) which is in a second predefined ratio to the stored reference, in particular is lower than a threshold value,
- converting kinetic energy of the means of transport (10) to electrical energy by raising the generator voltage to a predefined second value.

7. Method according to claim 5 or 6, wherein the predefined value to which the generator voltage is lowered is selected as a function of a nominal terminal voltage of the electrochemical energy storage system (1).

8. Method according to any one of the preceding claims 5 to 7, wherein the first predefined value represents a voltage in the range between 12.9 V and 13.7 V, preferably between 13.2 V and 13.5 V.

9. Method according to any one of the preceding claims 5 to 8, wherein
- the category with low usage is associated with an overrun operating state of the means of transport (10), and/or
- the category with higher usage is associated with a traction operating state of the means of transport (10).

10. Energy management control device for a means of transport (10), which is configured to carry out a method according to any one of the preceding claims.

11. Means of transport comprising
- an electrochemical energy storage system (1),
- a voltage sensor (2) for measuring a voltage of an on-board power system of the means of transport (10), and
- an energy management control device (3) according to claim 10.

## Revendications

1. Procédé pour déterminer une caractéristique d'un accumulateur d'énergie électrochimique (1) destiné à alimenter un réseau de bord d'un moyen de locomotion (10), en particulier d'un moyen de locomotion (10) sans module de données de batterie, comprenant les étapes de :
- détermination (100) d'un état de fonctionnement (II) prédéfini du réseau de bord,
- mesure (200) d'une tension de l'accumulateur d'énergie électrochimique (1) pendant l'état de fonctionnement (II) prédéfini et
- détermination (300) de la caractéristique de l'accumulateur d'énergie électrochimique (1) sur la base de la tension déterminée et d'une référence associée à l'état de fonctionnement (II) prédéfini, dans lequel
l'état de fonctionnement (II) prédéfini commence après un actionnement d'une fonction d'accès, mais se termine avant un démarrage (IV) d'un moteur à combustion interne (4) du moyen de locomotion (10),
**caractérisé en ce que** l'état de fonctionnement (II) prédéfini exclut un fonctionnement de consommateurs électriques (5) activés intentionnellement par un utilisateur du moyen de locomotion (10).

2. Procédé selon la revendication 1, dans lequel l'état de fonctionnement (II) prédéfini
- est démarré par l'actionnement de la fonction d'accès.

3. Procédé selon la revendication 1 ou 2, dans lequel
- dans l'état de fonctionnement (II) prédéfini, une puissance électrique absorbée simultanée d'un consommateur (6) prédéfini est prise en compte en utilisant une valeur enregistrée associée au consommateur (6) prédéfini et/ou dans lequel
- un historique d'utilisation du moyen de locomotion (10) et/ou
- un signal de température, en particulier une température de fluide de refroidissement et/ou
- une durée depuis un fonctionnement précédent le plus récent d'un moteur à combustion interne (4) du moyen de locomotion (10)
sont pris en compte lors de la détermination de la caractéristique.

4. Procédé selon l'une quelconque des revendications précédentes, dans lequel la caractéristique se base sur un SOH et/ou un SOC et/ou la référence est une valeur de tension associée à l'état de fonctionnement (II) prédéfini.

5. Procédé de régulation d'une tension d'alternateur d'un réseau de bord d'un moyen de locomotion (10), en particulier d'un moyen de locomotion (10) sans module de données de batterie, comprenant les étapes de :
- détermination (300) d'une caractéristique pour la puissance d'un accumulateur d'énergie électrochimique (1) dans le réseau de bord du moyen de locomotion (10) par un procédé selon l'une quelconque des revendications précédentes,
- catégorisation (400) d'un état de fonctionnement actuel en ce qui concerne une dépense d'énergie accumulée chimiquement pour transformer de l'énergie cinétique du moyen de locomotion (10) en énergie électrique et, aussi bien en réaction à une catégorie avec une dépense faible qu'en réaction à une caractéristique de l'accumulateur d'énergie électrochimique (1), qui se trouve dans un premier rapport prédéfini avec une référence enregistrée, en particulier qui est supérieure à une valeur seuil,
- réduction (500) de la tension d'alternateur à une première valeur prédéfinie.

6. Procédé selon la revendication 5, comprenant en outre les étapes, aussi bien en réaction à une catégorie avec une dépense faible qu'en réaction à une caractéristique de l'accumulateur d'énergie électrochimique (1), qui se trouve dans un second rapport prédéfini avec la référence enregistrée, en particulier qui est inférieure à une valeur seuil,
- transformation d'énergie cinétique du moyen de locomotion (10) en énergie électrique en augmentant la tension d'alternateur jusqu'à une seconde valeur prédéfinie.

7. Procédé selon la revendication 5 ou 6, dans lequel la valeur prédéfinie, à laquelle la tension d'alternateur est réduite, est sélectionnée en fonction d'une tension nominale aux bornes de l'accumulateur d'énergie électrochimique (1).

8. Procédé selon l'une quelconque des revendications 5 à 7, dans lequel la première valeur prédéfinie représente une tension comprise entre 12,9 V et 13,7 V, de préférence entre 13,2 V et 13,5 V.

9. Procédé selon l'une quelconque des revendications 5 à 8, dans lequel
- la catégorie avec la dépense faible est associée à un état de fonctionnement en poussée du moyen de locomotion (10) et/ou
- la catégorie avec la dépense plus élevée est associée à un état de fonctionnement en traction du moyen de locomotion (10).

10. Appareil de commande de gestion énergétique pour un moyen de locomotion (10), qui est conçu pour exécuter un procédé selon l'une quelconque des revendications précédentes.

11. Moyen de locomotion comprenant
- un accumulateur d'énergie électrochimique (1),
- un capteur de tension (2) pour mesurer une tension d'un réseau de bord du moyen de locomotion (10), et
- un appareil de commande de gestion énergétique (3) selon la revendication 10.
